# FASCICULE DE BREVET EUROPEEN

(11) **EP 1 373 941 B1**
(45) Date de publication et mention de la délivrance du brevet: **09.05.2012**
(21) Numéro de dépôt: 02720090.6
(22) Date de dépôt: 03.04.2002
(51) Int. Cl.: G06K 19/077, G01V 15/00, G06K 19/073, G07D 7/00

(54) **DOCUMENT AUTOCOLLANT INCORPORANT UN DISPOSITIF D'IDENTIFICATION RADIOFREQUENCE**
SELBSTKLEBENDES DOKUMENT MIT RADIOFREQUENZIDENTIFIKATIONSVORRICHTUNG
SELF-ADHESIVE DOCUMENT INCORPORATING A RADIOFREQUENCY IDENTIFICATION DEVICE

(30) Priorité: 05.04.2001 FR 0104637
(43) Date de publication de la demande: 02.01.2004
(73) Titulaire: ARJOWIGGINS SECURITY, 92100 Boulogne Billancourt (FR)
(72) Inventeur: RANCIEN, Sandrine, F-38140 La Murette (FR)
(74) Mandataire: Tanty, François
(86) Numéro de dépôt international: PCT/FR2002/001152
(87) Numéro de publication internationale: WO 2002/082126

(56) Documents cités:
- US-A- 5 763 058
- US-A- 5 949 059
- US-A- 6 094 133
- PATENT ABSTRACTS OF JAPAN vol. 2000, no. 16, 8 May 2001 (2001-05-08) & JP 2001 013874 A (MATSUSHITA ELECTRIC WORKS LTD), 19 January 2001 (2001-01-19)

## Description

La présente invention concerne le domaine des documents autocollants et plus particulièrement un document de sécurité autocollant tel qu'un visa, destiné à être collé sur un passeport.

Actuellement, les visas autocollants sont réalisés avec un papier de faible grammage, de telle sorte qu'en cas de tentative de décollement il se produise une délamination du papier.

Il a été proposé d'adjoindre aux documents de sécurité des dispositifs d'identification radiofréquence (RFID).

Ces dispositifs d'identification radiofréquence permettent d'accroître encore la sécurité en rendant plus difficile la falsification et augmentent la quantité de renseignements à la disposition des autorités lors d'un contrôle.

La demande JP 2001-013874 décrit une étiquette d'identification comportant une puce illisible après une tentative de décollement de l'étiquette.

Le brevet US 6 094 133 décrit un procédé de détection d'articles contrefaisants par incorporation d'identifiants dans les articles non contrefaits.

Le brevet US 5 949 059 décrit une étiquette de sécurité comportant un numéro de série associé à un dispositif de stockage électronique.

La présente invention a notamment pour objet d'améliorer la sécurité des documents autocollants munis d'un dispositif d'identification radiofréquence.

L'invention y parvient grâce à un document autocollant tel que défini dans la revendication 1.

Par «document», on entend tout type de structure relativement mince et souple, capable éventuellement de servir de support d'impression ou d'écriture, tel qu'un visa ou une étiquette destinée à garantir l'authenticité d'un article ou à indiquer un prix.

Grâce à l'invention, il est possible d'utiliser, pour réaliser le document autocollant; un papier de grammage relativement élevé, capable de protéger le dispositif d'identification radiofréquence et permettant de réaliser un document d'épaisseur sensiblement constante. La sécurité n'est pas diminuée, en dépit de la plus grande facilité de décollement du document en raison du grammage plus élevé du papier constituant la couche de recouvrement.

Il est donc possible d'utiliser, grâce à l'invention, un papier de grammage nettement plus important que dans les documents de sécurité autocollants connus, sans pour autant faciliter la tâche des faussaires.

On peut utiliser plusieurs types de dispositifs d'identification radiofréquence, notamment des dispositifs d'identification avec antenne intégrée dans la puce et des dispositifs d'identification avec antenne extérieure, réalisée par impression sur l'une des couches constitutives du document.

La réalisation d'une antenne de dimensions relativement importantes, au moyen d'une encre conductrice, permet d'accroître la portée de la liaison radio entre le dispositif d'identification et l'appareil de lecture et/ou d'écriture.

Il est également possible de réaliser la liaison entre la puce et l'antenne de telle sorte que l'adhérence de l'antenne sur le support soit supérieure à la solidité de la liaison entre l'antenne et la puce, de sorte qu'en cas de tentative de décollement du document, la liaison entre la puce et son antenne soit endommagée, la puce pouvant rester par exemple solidaire de la couche de recouvrement.

Lorsque l'antenne est réalisée par impression d'encre conductrice, on choisit le liant de l'encre de telle sorte que la force de cohésion de l'encre soit inférieure à la force d'adhérence de l'encre à la couche de recouvrement. Ainsi, en cas de tentative de décollement du document, l'antenne est endommagée, une partie de l'antenne pouvant rester solidaire du support et une autre partie de l'antenne pouvant rester solidaire de la couche de recouvrement. L'encre conductrice peut comporter des agents d'infalsification connus, sous réserve qu'ils soient compatibles avec l'encre.

L'antenne peut présenter une zone de rupture prédéterminée, destinée à faciliter son endommagement en cas de tentative de décollement du document du support.

Par exemple, cette zone de rupture prédéterminée peut être une zone amincie de l'antenne.

La couche adhésive peut présenter, dans différentes zones, des propriétés adhésives différentes vis-à-vis de l'antenne. Par exemple, la force d'adhérence de l'antenne à la couche adhésive située dans une première zone peut être inférieure à la force d'adhérence de l'antenne à la couche de recouvrement, et la force d'adhérence de l'antenne à la couche adhésive située dans une deuxième zone peut être supérieure à la force d'adhérence de l'antenne à la couche de recouvrement.

Ainsi, en cas de tentative de décollement du document, l'antenne peut rester solidaire de la couche de recouvrement dans la première zone et rester solidaire du support dans la deuxième zone.

L'invention sera mieux comprise à la lecture de la description qui va suivre, d'exemples de mise en oeuvre non limitatifs, et à l'examen du dessin annexé, sur lequel :
- la figure 1 est une coupe schématique d'un document de sécurité autocollant conforme à un exemple de mise en oeuvre de l'invention,
- la figure 2 représente le document de la figure 1, fixé sur un support,
- la figure 3 est une vue schématique illustrant le fait que la force d'adhérence de l'antenne au support est supérieure à la force d'adhérence de l'antenne à la couche de recouvrement,
- la figure 4 illustre le détachement de la couche de recouvrement, l'antenne restant solidaire du support,
- la figure 5 est une variante de réalisation illustrant le détachement de la couche de recouvrement, une partie de l'antenne restant solidaire du support et une partie de l'antenne restant solidaire de la couche de recouvrement,
- la figure 6 illustre l'enlèvement de la couche de recouvrement, dans le cas où la force de cohésion de l'encre est inférieure à la force d'adhérence de l'encre sur la couche adhésive et à la force d'adhérence de l'encre sur la couche de recouvrement,
- la figure 7 est un détail de la figure 6,
- la figure 8 illustre une variante de réalisation du document de sécurité autocollant, et
- la figure 9 illustre la formation d'une zone de rupture prédéterminée sur l'antenne.

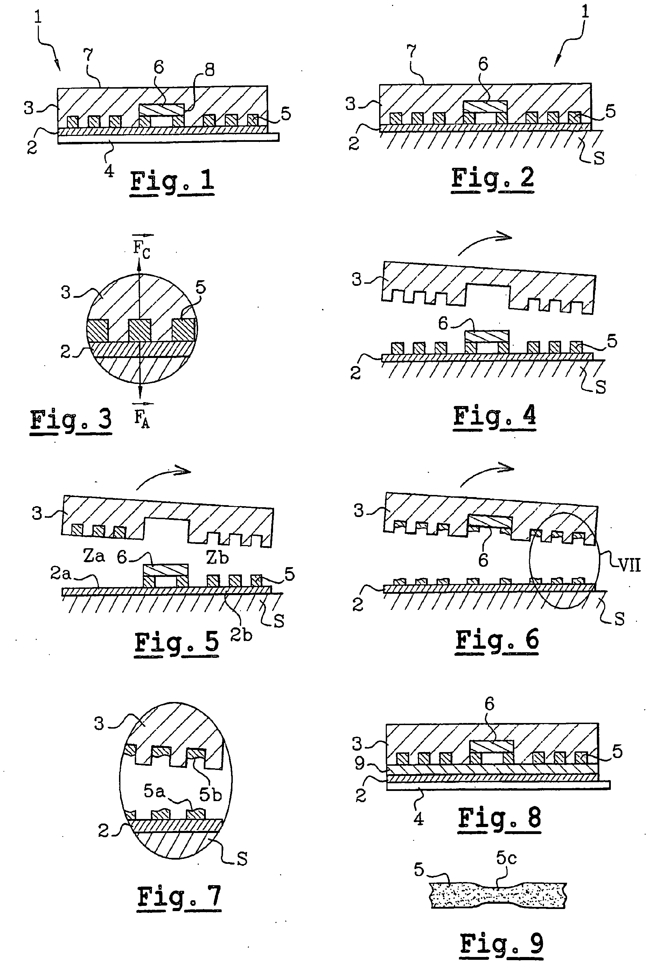

On a représenté, à la figure 1, un document de sécurité autocollant 1 tel qu'un visa adhésif, destiné à être apposé sur un passeport S, comportant une couche adhésive 2, une couche de recouvrement 3 et une pellicule de protection amovible 4 recouvrant la couche adhésive 2 avant collage du document 1 sur un support S, par exemple une page de passeport, comme illustré à la figure 2.

Sur la couche adhésive 2 a été réalisée, par impression d'une encre conductrice, une antenne 5.

Cette antenne 5 est reliée à une puce 6 afin de constituer un dispositif d'identification radiofréquence (RFID).

La couche de recouvrement 3 présente, dans l'exemple décrit, une face extérieure 7 imprimable.

L'épaisseur de la couche de recouvrement 3 est supérieure à celle de la puce 6, de manière à protéger celle-ci.

Une cavité 8 est formée dans la couche de recouvrement 3 de manière à loger la puce 6 et permettre au document de sécurité autocollant 1 de conserver une épaisseur sensiblement constante, sans surépaisseur sensible à l'aplomb du dispositif d'identification radiofréquence.

La couche de recouvrement 3 peut présenter une structure multicouche.

Conformément à l'invention, une tentative de décollement du document 1 de son support S par un faussaire provoque un endommagement du dispositif d'identification radiofréquence. En variante, ce dernier reste solidaire du support S, seule la couche de recouvrement 3 étant enlevée.

Une première possibilité pour parvenir à l'endommagement du dispositif d'identification en cas de tentative de décollement est illustrée aux figures 3 et 4, et consiste à choisir l'adhésif constituant la couche adhésive 2 de telle sorte que la force d'adhérence Fₐ de l'antenne sur la couche adhésive 2 soit supérieure à la force d'adhérence F_{c} de l'antenne sur la couche de recouvrement 3. Ainsi, en cas de tentative de décollement du document 1, l'antenne 5 reste solidaire du support S, comme illustré à la figure 4.

Il est également possible de réaliser la couche adhésive 2 de manière à ce que celle-ci présente une première partie 2a présentant des propriétés d'adhérence, vis-à-vis de l'antenne 5, différentes de celles d'une deuxième partie 2b.

La couche adhésive 2 peut notamment recevoir un traitement sur une partie de sa surface afin de présenter des propriétés adhésives non uniformes.

Dans l'exemple de la figure 5, la force d'adhérence de l'antenne 5 à la partie 2a située dans la zone Za est inférieure à la force d'adhérence de l'antenne 5 à la couche de recouvrement 3 et, dans la zone Zb, la force d'adhérence de l'antenne 5 à la partie 2b est supérieure à la force d'adhérence de l'antenne 5 à la couche de recouvrement 3.

Dans une variante non illustrée, on réalise la couche de recouvrement 3 de telle sorte que l'adhérence de la couche de recouvrement 3 à l'antenne 5 soit non homogène, de sorte qu'en cas de tentative d'enlèvement de la couche de recouvrement 3, une partie de l'antenne 5 reste solidaire du support S, provoquant l'endommagement du dispositif d'identification radiofréquence.

On choisit le liant de l'encre conductrice utilisée pour réaliser l'antenne 5 de telle sorte que la force de cohésion de l'encre soit inférieure à la force d'adhérence de l'encre sur la couche adhésive 2 et à la force d'adhérence de l'encre sur la couche de recouvrement 3. Ainsi, comme illustré à la figure 6, en cas d'enlèvement de la couche de recouvrement 3, la couche adhésive 2 reste sur le support S, les conducteurs électriques formés par le dépôt de l'encre conductrice se divisant en des parties 5a restant solidaires du support et en des parties 5b restant solidaires de la couche de recouvrement 3.

La faiblesse de la force de cohésion de l'encre peut également se traduire par une rupture des spires de l'antenne en un ou plusieurs points

Bien entendu, on peut donner au document de sécurité 1 une structure différente de celle illustrée à la figure 1.

On peut notamment, par exemple, réaliser l'antenne 5 par impression d'une encre conductrice non plus sur la couche adhésive mais sur une couche intermédiaire 9 située entre la couche adhésive 2 et la couche de recouvrement 3, comme représenté à la figure 8.

Dans ce cas, on choisit par exemple l'adhésif de sorte qu'en cas de tentative de décollement, une partie de l'antenne 5 reste solidaire de la couche intermédiaire 9 et cette dernière reste maintenue sur le support S par la couche adhésive 2.

L'antenne 5 peut être réalisée avec par exemple au moins une zone amincie 5c comme illustré à la figure 9, afin de favoriser l'endommagement de l'antenne en cas de tentative de décollement du document.

## Revendications

1. Document autocollant (1), comportant une couche adhésive (2) et au moins une couche de recouvrement (3) de la couche adhésive, incorporant un dispositif d'identification radiofréquence (5, 6), comportant une puce (6) et une antenne (5) réalisée par impression d'encre conductrice et extérieure à la puce, une partie de l'antenne étant liée au document avec une force de cohésion suffisamment faible pour qu'après collage du document sur un support, en cas de décollement du document, une partie au moins de l'antenne reste solidaire de la couche adhésive qui reste, au moins en partie, solidaire du support, de telle sorte que l'antenne soit endommagée, **caractérisé par le fait que** l'encre conductrice contient un liant choisi de telle sorte que la force de cohésion de l'encre soit inférieure à la force d'adhérence de l'encre à la couche de recouvrement.

2. Document autocollant selon la revendication 1, **caractérisé par le fait que** la liaison entre la puce (6) et l'antenne (5) est réalisée de telle sorte que l'adhérence de l'antenne (5) sur le support (S) soit supérieure à la solidité de la liaison entre l'antenne (5) et la puce (6), de sorte qu'en cas de tentative de décollement du document, la liaison entre la puce et son antenne soit endommagée.

3. Document autocollant selon l'une des revendications 1 à 2, **caractérisé par le fait que** l'encre comporte des agents d'infalsification.

4. Document autocollant selon l'une quelconque des revendications 1 à 3, **caractérisé par le fait que** l'antenne est réalisée avec au moins une zone amincie (5c) permettant de favoriser l'endommagement de l'antenne en cas de tentative de décollement.

5. Document autocollant selon l'une quelconque des revendications 1 à 4, **caractérisé par le fait que** la couche adhésive présente des parties (2a, 2b) ayant des propriétés adhésives différentes.

6. Document autocollant selon l'une quelconque des revendications 1 à 5, **caractérisé par le fait qu'**il ne présente pas de surépaisseur sensible à l'aplomb du dispositif d'identification radiofréquence.

7. Document autocollant selon l'une quelconque des revendications 1 à 6, **caractérisé par le fait que** le liant de l'encre est choisi de sorte que la force de cohésion de l'encre soit inférieure à la force d'adhérence de l'encre sur la couche adhésive.

## Claims

1. A sticky document (1) comprising an adhesive layer (2) and at least one covering layer (3) covering the adhesive layer, incorporating a radiofrequency identification device (5, 6) comprising a chip (6) and an antenna (5) formed by printing a conductive ink outside the chip, a portion of the antenna being linked to the document with a force of cohesion that is weak enough to ensure that once the document has been stuck onto backing, and in the event of the document being unstuck, at least a portion of the identification device remains secured to the backing, such that the antenna is damaged, **characterized by** the fact that the conductive ink comprises a binder chosen such that the force of cohesion of the ink is inferior to the force of adhesion of the ink with the covering layer.

2. A sticky document according to claim 1, **characterized by** the fact that the connection between the chip (6) and the antenna (5) is made in such a manner that adhesion between the antenna (5) and the backing (S) is stronger than the connection between the antenna (5) and the chip (6) such that in the event of an attempt at unsticking the document, the connection between the chip and its antenna is damaged.

3. A sticky document according to any of one of claims 1 to 2, **characterized by** the fact that the ink incorporates tamperproofing agents.

4. A sticky document according to any one of claims 1 to 3, **characterized by** the fact that the antenna is made to have at least one thin zone (5c) encouraging antenna breakage in the event of an attempt at unsticking.

5. A sticky document according to any one of claims 1 to 4, **characterized by** the fact that the adhesive layer presents portions (2a, 2b) having different adhesive properties.

6. A sticky document according to any one of claims 1 to 5, **characterized by** the fact that it does not present significant extra thickness over the radiofrequency identification device.

7. A sticky document according to any of claims 1 to 6, **characterized by** the fact that the binder is chosen such that the force of cohesion of the ink is inferior to the force of adhesion between the ink and the adhesive layer.

## Patentansprüche

1. Selbstklebendes Dokument (1), umfassend eine Klebeschicht (2) und mindestens eine Deckschicht (3) der Klebeschicht, welche eine Funkfrequenz-Identifikationsvorrichtung (5, 6) aufnimmt, die einen Chip (6) und eine durch Aufdrucken leitfähiger Tinte und außerhalb des Chips gebildete Antenne (5), wobei ein Abschnitt der Antenne mit dem Dokument mit einer hinreichend schwachen Kohäsionskraft verbunden ist, damit nach dem Aufkleben des Dokuments auf einen Träger, im Falle des Ablösens des Dokuments, wenigstens ein Abschnitt der Antenne mit der Klebeschicht zusammenbleibt, die zumindest teilweise mit dem Träger zusammenbleibt, so dass die Antenne beschädigt wird, **gekennzeichnet dadurch, dass** die leitfähige Tinte ein so ausgewähltes Bindemittel enthält, das die Kohäsionskraft der Tinte geringer als die Kraft des Anhaftens der Tinte an der Deckschicht ist.

2. Selbstklebendes Dokument nach Anspruch 1, **gekennzeichnet dadurch, dass** die Verbindung zwischen dem Chip (6) und der Antenne (5) so ausgebildet ist, dass das Anhaften der Antenne (5) am Träger (S) stärker als die Festigkeit der Verbindung zwischen der Antenne (5) und dem Chip (6) ist, so dass die Verbindung zwischen dem Chip und seiner Antenne beim Versuch des Ablösens des Dokuments beschädigt wird.

3. Selbstklebendes Dokument nach einem der Ansprüche 1 und 2, **gekennzeichnet dadurch, dass** die Tinte Mittel zur Fälschungssicherheit umfasst.

4. Selbstklebendes Dokument nach einem der Ansprüche 1 bis 3, **gekennzeichnet dadurch, dass** die Antenne mit mindestens einem verjüngten Bereich (5c) ausgebildet ist, der die Beschädigung der Antenne im Falle eines Ablösungsversuches ermöglicht.

5. Selbstklebendes Dokument nach einem der Ansprüche 1 bis 4, **gekennzeichnet dadurch, dass** die Klebeschichtabschnitte (2a, 2b) mit verschiedenen Klebeeigenschaften aufweist.

6. Selbstklebendes Dokument nach einem der Ansprüche 1 bis 5, **gekennzeichnet dadurch, dass** sie keine spürbare Verdickung in der Höhe der Funkfrequenz-Identifikationsvorrichtung aufweist.

7. Selbstklebendes Dokument nach einem der Ansprüche 1 bis 6, **gekennzeichnet dadurch, dass** das Bindemittel der Tinte so ausgewählt ist, dass die Kohäsionskraft der Tinte geringer als die Kraft des Anhaftens der Tinte an der Klebeschicht ist.
